# EUROPÄISCHE PATENTANMELDUNG

(11) **EP 3 242 045 A1**
(43) Veröffentlichungstag der Anmeldung: **08.11.2017**
(21) Anmeldenummer: 17174886.6
(22) Anmeldetag: 04.02.2015
(51) Int. Cl.: F16B 12/46, F16B 12/04, A47B 96/20, B32B 3/12, E04C 2/36, B27D 5/00, F16B 5/01

(54) **PROFILIERUNG ZUR VERBINDUNG VON PLATTEN**

(30) Priorität: 10.02.2014 DE 102014101600
(62) Teilanmeldung aus: 15153737.0
(71) Anmelder: Ebbinghaus, Heinrich, 33415 Verl (DE)
(72) Erfinder: Ebbinghaus, Heinrich, 33415 Verl (DE)
(74) Vertreter: Ostermann, Thomas

(57) **Zusammenfassung**

Die Erfindung betrifft eine Profilierung zur Verbindung von Platten (2, 6) an zueinander gekehrten Schmalseiten derselben, insbesondere für eine Leichtbauplatte für Möbel, wobei die Platten (2, 6) jeweils an den zueinander gekehrten Schmalseiten derselben eine erste ebene Anschlagfläche (27, 28) und eine zweite Anschlagfläche (30, 31) aufweisen, wobei die ersten Anschlagflächen der unmittelbar aneinander liegenden Platten sich in einer ersten Anschlagebene (A1) erstrecken und die zweiten Anschlagflächen der aneinander liegenden Platten sich in einer zweiten Anschlagebene erstrecken (A2), die in einem Winkel zu der ersten Anschlagebene (A1) angeordnet ist, dass die Platten an den Schmalseiten jeweils mindestens eine Erhebung (19, 20) und/oder eine Vertiefung (18, 21) einer solchen Erstreckung aufweisen, dass zum einen sich zwischen der Erhebung und der Vertiefung ein Zwischenraum bildet zur Aufnahme eines Klebemittels und zum anderen im zusammengesteckten Zustand der Platten äußere Grenzkanten der Platten bündig aneinander liegen.

## Beschreibung

Die Erfindung betrifft eine Profilierung für eine Leichtbauplatte nach dem Oberbegriff des Patentanspruchs 1.

Aus der DE 103 13 055 B4 ist eine Leichtbauplatte für Möbel bekannt, die aus zwei Decklagen und einer zwischen denselben angeordneten Kernlage mit einer wabenartigen Struktur besteht. Die Deckplatten sind randseitig mit einer Kantenleiste verbunden, sodass die Leichtbauplatte an einer Schmalseite abgeschlossen ist. Nachteilig an der bekannten Leichtbauplatte ist, dass sich stets eine Grenzkante zwischen der Kantenleiste einerseits und einer der beiden Decklagen andererseits bildet, sodass ein unerwünschter sichtbarer Übergang an diesen Grenzkanten sichtbar ist. Die Ausgestaltung der Kernlage durch eine Wabenstruktur verringert zwar das Gewicht der Leichtbauplatte. Nachteilig hieran ist jedoch, dass relativ aufwendig Maßnahmen getroffen werden müssen, um Befestigungsmittel bzw. Beschläge an der Leichtbauwand anzubringen.

Aufgabe der vorliegenden Erfindung ist es eine Profilierung für Platten anzugeben, damit auf einfache Weise ein homogener Übergang in einem Verbindungsbereich zwischen zweit Platten gewährleistet.

Zur Lösung der Aufgabe weist die Erfindung die Merkmale des Patentanspruches 1 auf.

Der Vorteil der erfindungsgemäßen Profilierung besteht darin, dass durch die Kombination von zwei ebenen Anschlagflächen unterschiedlicher Winkelorientierung und komplementärer Ausbildung einer Erhebung und Vertiefung der zu verbindenden Platten an einer Schmalseite derselben eine form- und stoffschlüssige Verbindung geschaffen wird, dass im montierten Zustand äußere Grenzkanten der aneinandergrenzenden Platten bündig aneinander liegen. Diese Profilierung ermöglicht durch eine Art Verhakung der Platte eine definierte relative Montageposition derselben zueinander, sodass stets ein glatter Übergang der aneinander grenzenden Grenzkanten der Platten gewährleistet ist. Vorzugsweise hat die Erhebung bzw. die Vertiefung eine solche Höhe bzw. Tiefe, dass eine innige Verhakung stattfindet und ein direktes und bündiges Aneinanderstoßen der Grenzkanten erzielt wird. Das Klebemittel ist somit lediglich in einem inneren Bereich zwischen einer äußeren Seite und einer inneren Seite dieses Verbindungsbereiches angeordnet, was dazu führt, dass das Klebemittel nicht an die Oberfläche gelangen kann. Nach Aneinandersetzen der zur verbindenden Platten (Deckplatte, Kantenleiste) bildet ein Zwischenraum in dem mittleren Bereich zwischen der äußeren und inneren Seite einen Kanal, in dem sich das Klebemittel verteilen kann. Vorteilhaft kann hierdurch eine sichere und saubere Verbindung geschaffen werden.

Nach einer Weiterbildung der Erfindung weisen die Vertiefung bzw. Erhebung eine solche Tiefe bzw. Höhe auf, dass durch Verhakung eine gezielte und immer wiederkehrende Fügeposition eingestellt werden kann, in der das Klebemittel aushärtet. Vorteilhaft kann hierdurch ein gleichbleibendes Verbindungsergebnis erzielt werden.

Weitere Vorteile der Erfindung ergeben sich aus den weiteren Unteransprüchen.

Ausführungsbeispiele der Erfindung werden nachfolgend anhand der Zeichnungen näher erläutert.

Es zeigen:
- Figur 1: einen teilweisen Querschnitt durch eine Leichtbauplatte, die als eine Seitenwand für ein Möbelstück verwendet wird,
- Figur 2: eine schematische Ansicht der Leichtbauplatte gemäß Figur 1 in Richtung X,
- Figur 3: einen Querschnitt durch die gesamte Leichtbauplatte im verleimten, aber noch nicht umhüllten Zustand gemäß Figur 1,
- Figur 4: eine vergrößerte Darstellung einer Profilverbindung in einem Kantenbereich der Leichtbauplatte,
- Figur 5: einen teilweisen Querschnitt einer Leichtbauplatte mit einer Kantenleiste eines ersten Dekorprofils,
- Figur 6: einen teilweisen Querschnitt einer Leichtbauplatte mit einer Kantenleiste eines zweiten Dekorprofils,
- Figur 7: einen teilweisen Querschnitt einer Leichtbauplatte mit einer Kantenleiste eines dritten Dekorprofils,
- Figur 8: einen Querschnitt durch eine Leichtbauplatte, die als ein Tischfuß verwendet wird, und
- Figur 9: einen Querschnitt durch eine dreieckförmige Leichtbauplatte.

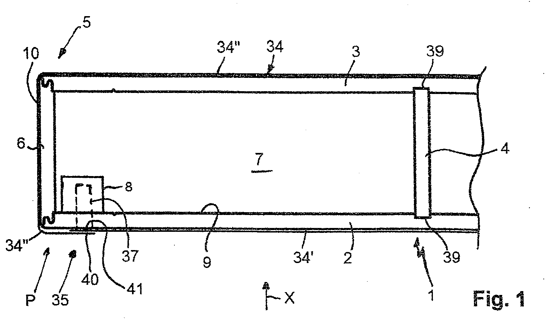

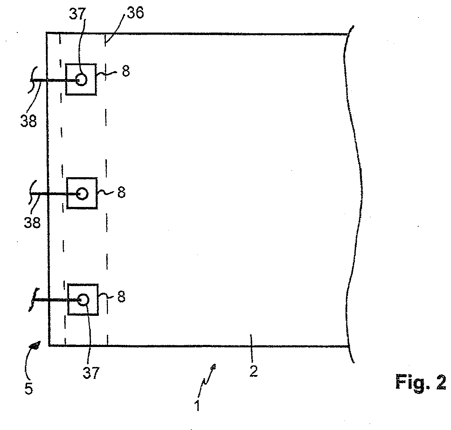

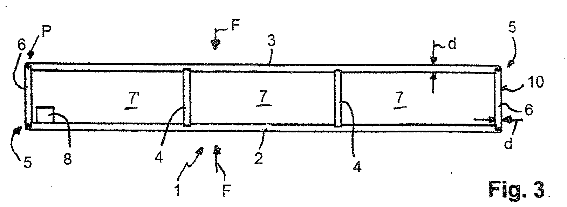

Eine Leichtbauplatte 1 nach einer ersten Ausführungsform der Erfindung gemäß den Figuren 1 bis 7 kann bspw. als eine Seitenwand für einen Schrank oder Regal eingesetzt werden.

Die Leichtbauplatte 1 weist eine erste Deckplatte 2 und eine parallel zu derselben verlaufende zweite Deckplatte 3 auf. Ein Abstand zwischen diesen beiden Deckplatten 2, 3 wird durch eine Anzahl von in einem Abstand zueinander, vorzugsweise parallel angeordneten Stützelementen 4 sowie an gegenüberliegenden Schmalseiten 5 der Leichtbauplatte 1 angeordneten Kantenleisten 6 vorgegeben.

Die erste Deckplatte 2 und die zweite Deckplatte 3 bilden jeweils eine Decklage der Leichtbauplatte 1 mit einer relativ großen Fläche. Die Stützelemente 4 sind als relativ dünnwandige Stützplatten ausgebildet, die etwa die gleiche Dicke aufweisen wie die Kantenleisten 6. Die Stützplatten 4 bilden eine Kernlage der Leichtbauplatte 1. Zwischen den Stützplatten 4 erstrecken sich Hohlräume 7. Die Stützplatten 4 sind in einem solchen Abstand zueinander angeordnet, dass die Leichtbauplatte 1 eine ausreichende Stabilität aufweist.

In einem randseitigen Hohlraum 7' ist zusätzlich eine Anzahl von Aufnahmeelementen 8 angeordnet, die zur Aufnahme von Befestigungsmitteln für weitere Möbelteile, bspw. einer Tür oder einer weiteren Leichtbauplatte, dienen. Das Aufnahmeelement 8 ist als ein Aufnahmeblock oder Aufnahmeklotz ausgebildet, der auf einer Innenseite 9 der ersten Deckplatte 2 mit derselben stoffschlüssig verbunden ist, bspw. durch Verleimung.

Nach einer alternativen Ausführungsform der Erfindung ist das Aufnahmeelement 8 sowohl an der Innenseite der ersten Deckplatte 2 als auch an einer Innenseite der zweiten Deckplatte 3 stoffschlüssig befestigt, bspw. durch Verleimung.

Nach einer ersten Ausführungsform der Leichtbauplatte 1 gemäß den Figuren 1 bis 4 weist die Kantenleiste 6 eine ebene Oberfläche 10 auf.

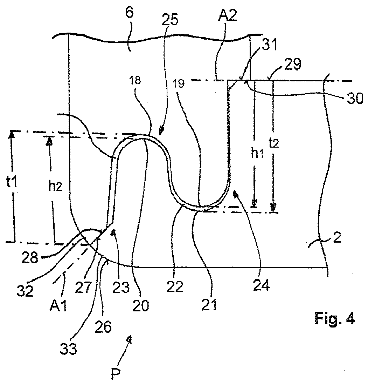

Wie besser aus Figur 4 ersichtlich ist, weist die Kantenleiste 6 und die erste Deckplatte 2 an ihrer Schmalseite eine Profilierung P auf. Die Kantenleiste 6 weist an ihrer Schmalseite eine Vertiefung 18 und eine benachbarte Erhebung 19 auf, die zu einer Erhebung 20 bzw. Vertiefung 21 der ersten Deckplatte 2 korrespondieren. Eine Tiefe t₁ der Vertiefung 18 und eine Höhe h₁ der Erhebung 19 ist so zu einer Höhe h₂ der Erhebung 20 und einer Tiefe t₂ der Vertiefung 21 abgestimmt, dass sich zwischen der jeweiligen Vertiefung 18 und Erhebung 20 bzw. Erhebung 19 und Vertiefung 21 ein Zwischenraum 22 zur Aufnahme eines Klebemittels bildet. Vorzugsweise wird als Klebemittel ein Leim verwendet, der sich kontinuierlich in dem Zwischenraum 22 verteilen kann. Der Zwischenraum 22 erstreckt sich quasi als wellenförmiger Kanal zwischen einem äußeren Ende 23 und einem inneren Ende 24 eines bogenförmigen Verbindungsabschnittes. Der Zwischenraums 22 erstreckt sich durchgehend von einem Ende zu einem anderen Ende der Schmalseite von Deckplatte 2 und Kantenleiste 6.

Die erste Deckplatte 2 und die zweite Deckplatte 3 weisen an ihren gegenüberliegenden Enden (Schmalseiten) die gleiche Profilierung P auf. Die Deckplatten 2 und 3 können somit als Gleichteile gefertigt werden. Auch die Kantenleisten 6, die an den gegenüberliegenden Schmalseiten der ersten Deckplatte 2 und der zweiten Deckplatte 3 angeordnet sind, weisen die gleiche Profilierung P auf. Die Kantenleisten 6 können somit auch als Gleichteile gefertigt werden.

An dem äußeren Ende 23 des eine Verhakung 25 bildenden bogenförmigen Verbindungsabschnittes schließt sich eine ebene Anschlagfläche 27 der Kantenleiste 6 und eine ebene Anschlagsfläche 28 der ersten Deckplatte 2 an. Die Anschlagfläche 27 der Kantenleiste 6 und die Anschlagfläche 28 der ersten Deckplatte 2 liegen unmittelbar aneinander an einer Außenseite 26 der Leichtbauplatte 1. Im Bereich einer Innenseite 29 der Leichtbauplatte schließt sich an dem inneren Ende des bogenförmigen Verbindungsabschnittes eine ebene Anschlagsfläche 30 der Kantenleiste 6 und eine korrespondierende ebene Anschlagsfläche 31 der ersten Deckplatte 2 an, die unmittelbar aneinander liegen. Die Anschlagfläche 27 und 28 erstrecken sich in einer Anschlagebene A1, die in einem spitzen Winkel zu einer Anschlagebene A2 verläuft, in der sich die Anschlagfläche 30 und 31 erstrecken.

Das Klebemittel kann sich somit nur in dem inneren Verbindungsabschnitt zwischen der Deckplatte 2, 3 und der Kantenleiste 6 vertiefen, wobei sie die Flächen der Vertiefungen 18, 21, bzw. Erhebungen 19, 20 benetzt.

Die Vertiefungen 18, 21 bzw. Erhebungen 19, 20 der Deckplatten 2, 3 sowie der Kantenleisten 6 verlaufen kontinuierlich bzw. stetig. Im Querschnitt können sie parabelförmig ausgebildet sein. Hierdurch ist gewährleistet, dass sich zwischen dem äußeren Ende 23 und dem inneren Ende 24 des Verbindungsabschnittes durchgehend das Klebemittel verteilen kann und eine innige und feste stoffschlüssige Verbindung zwischen der Deckplatte 2, 3 und der Kantenleiste 6 ermöglicht.

Die Vertiefungen 18, 21 bzw. Erhebungen 19, 20 weisen eine solche Tiefe t₁, t₂ bzw. Höhe h₁, h₂ auf, dass beim Zusammenfügen eine definierte Relativlage zwischen der ersten Deckplatte 2, 3 und der Kantenleiste 6 gewährleistet ist. Ein Nachjustieren ist nicht erforderlich. Dies wird begünstigt durch die in einem Winkel zueinander angeordneten Anschlagebenen A1, A2. Die Tiefe t₁ bzw. t₂ ist größer als die Höhe h₁ bzw. h₂, sodass stets der Zwischenraum 22 zwischen den Flächen der Vertiefung 18 und der Erhebung 19 der Kantenleiste 6 einerseits und der Erhebung 20 und Vertiefung 21 der Deckplatte 2, 3 andererseits beim Zusammenstecken gegeben ist.

Die Verbindungsprofilierung, die aus dem Vertiefungen 18, 21 und Erhebungen 19, 20 einerseits und den Anschlagflächen 27, 28, 30, 31 andererseits besteht, ermöglicht zuerst eine formschlüssige und dann eine stoffschlüssige Verbindung zwischen den Kantenleisten 6 einerseits und den Deckplatten 2, 3 andererseits. Grenzkanten 32 der Kantenleiste 6 einerseits und Grenzkanten 33 der Deckplatte 2 bzw. 3 andererseits liegen bündig aneinander, ohne dass sich ein Versatz oder Übergang zwischen der Kantenleiste 6 und der Deckplatte 2, 3 ergibt.

Die Tiefen t₁, t₂ bzw. die Höhen h₁, h₂ können in einem Bereich von 50% bis 80% einer Wanddicke d der Deckplatte 2, 3 oder der Kantenleiste 6 sein.

Damit die Leichtbauplatte 1 ein gewünschtes Erscheinungsbild aufweist, ist diese mit einer Umhüllung 34 versehen. Die Umhüllung 34 ummantelt die Leichtbauplatte 1 in Umfangsrichtung, wobei die gegenüberliegenden Kantenleisten 6 mit überdeckt werden. Ein Überlappungsbereich 35 der Umhüllung 34 ist in einem solchem Bereich der Leichtbauplatte 1 vorgesehen, der im montieren Zustand durch ein Möbelstück abgedeckt ist bzw. als Anschlag für ein weiteres zu verbindendes Möbelteil dient. Im vorliegenden Ausführungsbeispiel bildet der Überlappungsbereich 35 einen Randstreifen 36 der ersten Deckplatte 2, an dem sich innenseitig der ersten Deckplatte 2 die Aufnahmeklötze 8 in einem vorgegebenen Abstand zueinander erstrecken. Diese Aufnahmeklötze 8 weisen Bohrungen 37 auf, in denen Beschläge 38 des benachbarten Möbelteils, bspw. einer Tür, eingreifen können. Die Beschläge 38 können bspw. als Scharniere ausgebildet sein. Auf diese Weise befindet sich der Überlappungsbereich 35 in einem kantenfernen Bereich bzw. zu einem im Wesentlichen nicht sichtbaren Bereich der Leichtbauplatte 1. Die Bohrung 37 kann als eine Sackloch- oder Durchgangsbohrung zur Aufnahme des Befestigungsmittels ausgebildet sein, wobei diese Bohrung 37 zu einer Bohrung der ersten Deckplatte 2 fluchtet. Die Umhüllung 34 ist vorzugsweise einstückig ausgebildet.

Der Aufnahmeklotz 8 ist vorzugsweise ausschließlich mit der ersten Deckplatte 2 verbunden, wobei die Höhe des Aufnahmeblocks 8 von dem verwendeten Befestigungsmittel abhängt.

Zur Herstellung der Leichtbauplatte 1 wird die erste Deckplatte 2 an an einer Flachseite derselben angeordneten inneren Nuten 39 mit einem Klebemittel versehen, sodass danach die Stützplatten 4 unter formschlüssigem Eingriff in die jeweiligen Nut 39 sowie die Kantenleiste 6 an den Enden der ersten Deckplatte 2 angesetzt werden können. Allein aufgrund des Formschlusses sind die Klemmleisten 6 und die Stützplatten 4 an der ersten Deckplatte 2 gehalten. In einem zweiten Schritt wird die zweite Deckplatte an den freien gegenüberliegenden Enden der Kantenleiste bzw. über an einer Flachseite der zweiten Deckplatte 3 angeordneten Nuten 39 an die Stützplatten 4 angesetzt, wobei vorher an den Verbindungsstellen ein Klebemittel aufgetragen worden ist.

Anschließend wird durch Einwirken einer auf die erste Deckplatte 2 und die zweite Deckplatte 3 entgegengesetzt gerichtete Kraft F die Leichtbauplatte 1 verpresst. Nach Aushärtung des Klebemittels wird die Leichtbauplatte 1 dann mit der Umhüllung 34 versehen.

Wie insbesondere aus Figur 1 ersichtlich ist, besteht die Umhüllung 34 aus einer kurzen Umhüllungsbahn 34' und einer langen Umhüllungsbahn 34". Die kurze Umhüllungsbahn 34' wird auf eine Außenseite der ersten Deckplatte 2 aufgebracht. Die lange Umhüllungsbahn 34" wird danach auf eine Außenseite der zweiten Deckplatte 3 sowie den gegenüberliegenden Kantenleisten 6 aufgebracht, wobei ein Ende 40 der langen Umhüllungsbahn 34" in dem Randstreifen 36 der ersten Deckplatte 2 auf ein Ende 41 der kurzen Umhüllungsbahn 34' zur Anlage kommt. Durch Wärme und Druck wird dann eine konturfolgende Anlage der kurzen und langen Umhüllungsbahnen 34', 34" auf der Außenseite der Leichtbauplatte 1 erzielt. Die Umhüllung 34 kann bspw. aus einer Folie oder auch aus einer Papierlage bestehen.

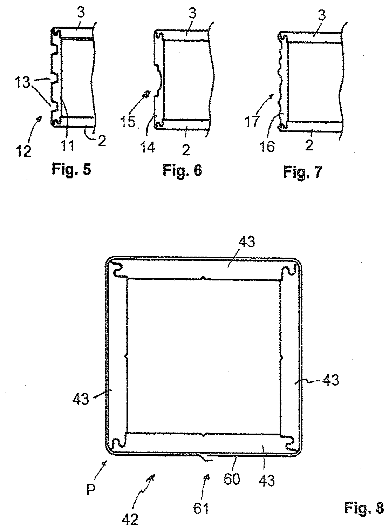

Nach einer alternativen Ausführungsform der Erfindung gemäß Figur 5 kann eine Kantenleiste 11 mit einem ersten Dekorprofil 12 an der Oberfläche ausgebildet sein. Das erste Dekorprofil 12 besteht aus einer Anzahl von trapezförmigen Einschnitten 13, die sich beabstandet zueinander parallel zu den Deckplatten 2, 3 erstrecken.

Nach einer alternativen Ausführungsform gemäß Figur 6 kann eine Kantenleiste 14 mit einem zweitem Dekorprofil 15 ausgebildet sein, das eine flußbettartige Vertiefung aufweist, die sich mittig in Erstreckungsrichtung der Kantenleiste 14 verläuft.

Nach einer weiteren Ausführungsform der Erfindung gemäß Figur 7 kann eine Kantenleiste 16 ein drittes Dekorprofil 17 aufweisen, das eine wellenförmige Oberflächenstruktur aufweist.

Die Kantenleisten 6, 11, 14, 16 unterscheiden sich lediglich durch die außenseitige Oberflächenstruktur. Zur Verbindung mit der ersten Deckplatte 2 und der zweiten Deckplatte 3 weisen diese an ihren Schmalseiten eine gleiche Profilierung auf, die mit einer Profilierung der ersten Deckplatte 2 bzw. zweiten Deckplatte 3 zusammenwirkt.

Nach einer weiteren Ausführungsform der Erfindung gemäß Figur 8 kann eine Stützeinheit, bspw. ein Fuß 42 für einen Tisch oder dergleichen vorgesehen sein. Der Fuß 42 unterscheidet sich im Wesentlichen von Leichtbauplatte 1 dadurch, dass er keine inneren Stützelemente 4 bzw. Aufnahmeelemente 8 aufweist. Der Fuß 42 weist lediglich vier Platten 43 auf, deren Schmalseiten die Profilierung P der Kantenleisten 6 bzw. der Deckplatten 2, 3 aufweisen. Diese Platten 43 sind außenseitig durch eine einstückige Umhüllung 60 ummantelt, wobei in einem kantenfernen mittleren Bereich einer Außenseite der Platte 43 ein Überlappungsbereich 61 gebildet wird.

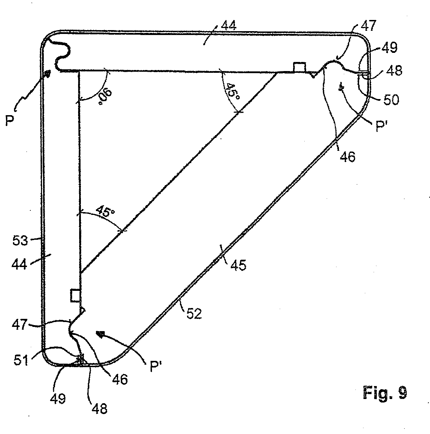

Nach einer alternativen Ausführungsform der Erfindung gemäß Figur 9 kann eine Stützeinheit auch im Querschnitt dreieckförmig ausgebildet sein mit zwei gleichen Platten 44, die in einem rechten Winkel zueinander angeordnet sind, sowie einer schrägen Platte 45. Die Platten 44 weisen auf einer zueinander gekehrten Schmalseite die gleiche Profilierung P auf, wie in den vorgenannten Ausführungsbeispielen. An den hierzu gegenüberliegenden Schmalseiten sowie an den entsprechenden Schmalseiten der schrägen Platte 45 ist eine alternative Profilierung P' vorgesehen, die lediglich eine einzige Vertiefung 46 der Platten 44 und eine einzige Erhebung 47 bzw. der schrägen Platte 45 vorsieht. Äußere Anschlagflächen 48, 49 der Platten 44 bzw. schrägen Platte 45 im Bereich der Profilierung P' weisen eine solche Breite auf, dass Enden 50 einer kurzen Umhüllungsbahn 52, die eine Außenfläche der schrägen Platte 45 bedecken und Enden 51 einer lange Umhüllungsbahn 53, die beide Außenflächen 49 der Platten 44 überdecken zur Anlage kommen können. Die Umhüllung erfolgt bei dieser Ausführungsform, bevor die bereits zusammengefügten beiden Platten 44 mit der schrägen Platte 45 formschlüssig und stoffschlüssig verbunden werden.

Gleiche Bauteile bzw. Bauteilfunktionen der Ausführungsbeispiele sind mit den gleichen Bezugszeichen versehen.

## Patentansprüche

1. Profilierung zur Verbindung von Platten an zueinander gekehrten Schmalseiten derselben, insbesondere für eine Leichtbauplatte für Möbel, die zwei Decklagen und eine zwischen den beiden Decklagen (2, 3) angeordnete Kernlage aufweist und die eine Kantenleiste (6) aufweist, die an einer Schmalseite (5) der Leichtbauplatte (1) mit der Decklage (2, 3) verbunden ist, **dadurch gekennzeichnet,**
- **dass** die Platten (2, 3, 6) jeweils an den zueinander gekehrten Schmalseiten derselben eine erste ebene Anschlagfläche (27, 28) und eine zweite Anschlagfläche (30, 31) aufweisen, wobei die ersten Anschlagflächen (27, 28) der unmittelbar aneinander liegenden Platten sich in einer ersten Anschlagebene erstrecken und die zweiten Anschlagflächen der aneinander liegenden Platten (2, 3, 6) sich in einer zweiten Anschlagebene (A2) erstrecken, die in einem Winkel zu der ersten Anschlagebene (A1) angeordnet ist,
- **dass** die Platten (2, 3, 6) an den Schmalseiten jeweils mindestens eine Erhebung (19, 20) und/oder eine Vertiefung (18, 21) einer solchen Erstreckung aufweisen, dass zum einen sich zwischen der Erhebung (19, 20) und der Vertiefung (18, 21) ein Zwischenraum (22) bildet zur Aufnahme eines Klebemittels und zum anderen im zusammengesteckten Zustand der Platten (2, 3, 6) äußere Grenzkanten (32, 33) der Platten bündig aneinander liegen.

2. Profilierung nach Anspruch 1, **dadurch gekennzeichnet, dass** die ebenen Anschlagflächen (27, 28, 29) der Platten an einer Innenseite (29) und an einer Außenseite (26) der Platten angeordnet sind.

3. Profilierung nach Anspruch 1 oder 2, **dadurch gekennzeichnet, dass** die Anschlagflächen (27, 28, 29) der Platten (2, 3, 6) unmittelbar aneinander liegen.
